# EUROPEAN PATENT SPECIFICATION

(11) **EP 2 919 572 B1**
(45) Date of publication and mention of the grant of the patent: **17.01.2018**
(21) Application number: 14405024.2
(22) Date of filing: 14.03.2014
(51) Int. Cl.: H05K 7/20, H05K 7/14

(54) **Modular power supply**
Modulare Stromversorgung
Alimentation électrique modulaire

(43) Date of publication of application: 16.09.2015
(60) Divisional application: 17206249.9
(73) Proprietor: DET International Holding Limited, George Town, Grand Cayman (KY)
(72) Inventor: Springett, Nigel, 79312 Emmendingen (DE)
(74) Representative: Stäbler, Roman

(56) References cited:
- US-A- 5 973 923
- US-A1- 2001 040 812
- US-A1- 2003 198 022
- US-A1- 2006 164 811
- US-A1- 2012 287 582

## Description

### Technical Field

The invention relates to a power supply including at least one power module, where each power module includes a first plate-like heat sink, a second plate-like heat sink, a first PCB and a power circuit, where the plate-like heat sinks are arranged in parallel at a distance and the first PCB is arranged between the plate-like heat sinks. The invention further relates to a corresponding power supply and a corresponding method for providing such a power supply.

### Background Art

Document US 6,072,697 (Systems & Electronics Inc.) discloses an enclosure containing a power supply, a camera and several printed circuit boards (PCB) with processing electronics and other electric circuits. The PCBs are stacked and in order to prevent an overheating of the components that are arranged on the PCBs, a heat sink apparatus provides a heat conduction path from the components to the enclosure. The heat sink apparatus includes a plurality of heat conductive plates that are arranged between the PCBs. In order to enhance the heat transfer, pouches including a liquid heat sink material or elastomer pads are arranged between the components and the heat conductive plates as well as between the heat conductive plates and the enclosure. The power consumed by the device is about 40 to 50 watts.

Since the heat sink apparatus is a conduction cooled device, the heat is mainly transferred to the enclosure at those places where the heat conductive plates are in direct contact with the enclosure (via the pouches or pads). Accordingly, this solution does not work in arrangements where not all of the PCBs with the heat producing components are in direct contact with the enclosure. And in case of such a device that consumes more power than the 40 to 50 watts mentioned in this document, it is hardly possible to enhance the heat transfer to the enclosure because it does not seem to be easy to substantially increase the number of heat conductive plates within the enclosure, simply because the heat conductive plates have to be arranged directly near the PCBs and there is no room left for additional plates. But, one of the main disadvantages is that the disclosed heat sink apparatus is neither able nor suited to dissipate the heat produced by the power supply. This becomes even more important if the power consumed by the device increases.

The US 2012 287 582 A1 (Vinciarelli) discloses a power converter. It includes a printed circuit board ("PCB") and a magnetic core structure, having an upper and a lower E-core separated by a gap. The PCB is moulded between two mold panels which can provide heat sink surfaces. Protruding components of the PCB panel and the E-cores are accommodated by recesses in the heat sinks. According to the Figures, there is everywhere a small gap between the electrical components and the heat sink panels. These spaces are filled with moulding compound which provides a thermally conductive medium to conduct heat away from the PCB and components to the heat sinks.

The US 2012 287 582 A1 (Vinciarelli) does not show an electric insulator between the two core parts which defines a gap.

### Summary of the invention

It is therefore an object of the invention to create a power supply pertaining to the technical field initially mentioned, that is simple in construction, is low cost and exhibits an improved cooling performance. Further objects of the invention are to create a corresponding electrically operated device as well as a method for providing such a power supply.

The solution of the invention is specified by the features of claim 1. The power supply includes at least one power module, where each power module includes a first plate-like heat sink, a second plate-like heat sink, a first PCB and a power circuit. The plate-like heat sinks are arranged in parallel at a distance and the first PCB is arranged between the plate-like heat sinks. According to the invention the power circuit includes a planar transformer with windings and a magnetic core wherein the windings are formed by traces on the first PCB and wherein the magnetic core is thermally connected to at least one of the plate-like heat sinks.

Since the magnetic core is in thermal contact with the plate-like heat sink, the heat generated within the core is efficiently transferred to that heat sink. But moreover, a part of the heat generated by the core is also transferred to the other plate-like heat sink either through the air (or any other substance that is present between the core and the other heat sink) or through other thermal paths.

At least one, preferably both of the plate-like heat sinks mainly include, or are made of a material with a high thermal conductivity which means that the heat transferred to the heat sinks is rapidly dispersed within the heat sinks. The heat sinks themselves are convection cooled which means that the heat from the heat sinks is transferred to the air (or another fluid) flowing along the surface of the heat sink. Due to their plate-like shape, the heat sinks have a large area to transfer the heat to the flowing air such that the power supply according to the invention is very efficiently cooled. The convection is preferably a natural convection, i. e. it is produced by the natural air ascension due to its temperature rise. But the convection may also be a forced convection produced by a fan or the like.

In this way, each module of the power supply can be made self-cooling i. e. it does not rely on any additional cooling by the case or any other device. The power supply is therefore very easily scalable such that the number of modules can simply be adjusted to the power required. If two or more modules are necessary in a particular application these modules may in general be arranged in any suitable way. They may for example be arranged such that their heat sinks include an arbitrary angle between zero and 180 degrees and they may be irregularly spaced and/or distributed in the available area. Multiple modules are however advantageously arranged such that their plate-like heat sinks are parallel to each other, they are arranged in a row and regularly spaced. Preferably, the distance between two modules corresponds to the distance between the plate-like heat sinks of a single module such that the distance between two arbitrary neighbouring plate-like heat sinks is the identical.

The traces on the first PCB that form the windings of the transformer are preferably formed by electric conductors provided on a layer of the PCB where this layer might either be an outer layer or an inner layer of the PCB. These traces are for example made by a PCB etching process as known in the art.

The distance between the plate-like heat sinks depends on the thickness of the module, particularly on the space that is needed by those components of the power circuit that are provided between the two plate-like heat sinks. All or at least most of these components are mounted on the PCB.

The term thermally connected in this connection and also throughout the rest of this document means that the core or any other device is arranged either in direct contact with the heat sink or that just a thin layer of a material is positioned between the device and the heat sink. In order to enable an efficient heat transfer from the device to the heat sink, this material may for example have a high thermal conductivity. Or the material may just be an electrical insulator or it is an electrical insulator with a high thermal conductivity. This term should also include arrangements where two or more thin layers of such materials are provided between the device and a heat sink.

In a preferred embodiment of the invention, the PCB is not a single-layer but a multi-layer PCB, for example a two-layer PCB in which case, the windings of the transformer, i. e. the traces are provided on different layers of the PCB. However, even in the case of a multi-layer PCB the windings could be provided on just a single layer. But the number of turns of a the windings can be enlarged if the windings are distributed on two or even more layers which allows to more flexibly adapt the power supply to the specific requirements of a particular application. The magnetic core includes two core parts such as for example I-shaped, U-shaped or E-shaped core parts or any suitable mixture of such parts. In the invention, an electrical insulator is arranged between the two core parts. This insulator is useful where a specific degree of insulation has to be provided, for example between the primary and the secondary of the transformer. Accordingly, one of the core parts bears the windings of the transformers primary and the other bears the windings of the transformers secondary.
Moreover, the insulator not only provides insulation but at the same time preferably also defines a gap between the magnetic core parts to increase the magnetic resistance which might be advantageous in certain applications.
Several pieces of insulator may for example be provided between two corresponding legs of the two core halves. Or a single piece of insulator may be provided to separate the two core parts from each other. In a preferred embodiment, an enlarged single piece of insulator is provided between the two core parts. Enlarged in this content means that the insulator protrudes the core on a least one side, preferably on two or more sides. By extending the insulator in this way the safety isolation, for example between the transformers primary and secondary can be enhanced.
In an even more preferred embodiment, the insulator is formed by a PCB such as for example a sheet of glass-reinforced epoxy laminate. For example a sheet of an FR4 PCB having a thickness of about 0.1 mm to 2 mm may be used.
If such a PCB is used as the insulator between the two core parts, this PCB preferably also includes traces forming windings of the planar transformer.
As already mentioned, the magnetic core is thermally connected to at least one of the plate-like heat sinks. In another preferred embodiment of the invention, not only one but both (or in case of more than two core parts some or all of them) are thermally connected to at least one of the heat sinks. In this way, the heat transfer from the core to the heat sinks may be further enhanced. In case of two core parts, preferably one of them is thermally connected to one of the heat sinks and the other is thermally connected to another one of the heat sinks. In a specifically preferred embodiment, one of the magnetic core parts is thermally connected to one of the heat sinks, and the other magnetic core part is thermally connected to another one of the heat sinks. Accordingly, one of the plate-like heat sinks is arranged on opposed sides of the transformer.

If the transformer windings of the primary and secondary are separately wound on the core parts, preferably one of the plate-like heat sinks is referenced primary side of the transformer and the other plate-like heat sink is referenced to the secondary.

The first PCB which is arranged between the plate-like heat sinks can be positioned such that it forms an angle with the heat sinks that is different from 0 degrees such as for example an angle between 20 and 70 degrees. The angle may however also be smaller or larger. But preferably, the first PCB is arranged in parallel to the plate-like heat sinks. The advantage of such an arrangement is that the air for the convection cooling may not only flow on the outside of the two heat sinks of a power module but also between them with as less obstructions as possible.

In a further preferred embodiment of the invention, the power supply according to the invention includes a second PCB. It may also include a third or even more PCBs. The features outlined above in connection with the first PCB also apply to the further PCBs provided. They are for example also preferably arranged in parallel to the plate-like heat sinks and therefore in parallel to the first PCB. They may also be single- or multilayer PCBs and include traces on one or more of their layers that form windings of the transformer. Components of the power circuit may also be mounted on one or several of these additional PCBs.

A power circuit often includes also further components like for example resistors, capacitors, inductors, integrated circuits or other electrical components. And in addition to the magnetic core the power circuit usually also includes other heat producing components such as for example transistors or diodes. And each power module may also include more than one magnetic core that is either a part of the power circuit or of a different part of the power module.

In order to also enhance the heat transfer from such components to a heat sink the power circuit includes in a preferred embodiment of the invention a first heat producing component that is thermally connected to one of the heat sinks.

And in an even more preferred embodiment, a second heat producing component of the power circuit is thermally connected to another one of the heat sinks. For example, the first heat producing component is a transistor and the second heat producing component is a diode where either one or both of them are mounted on a PCBs provided between the heat sinks. They may be mounted on the same or different PCBs.

The heat producing component may be in direct contact with the heat sink. This may however result in an electrical connection between the heat sink and that part of the component that is in contact with it. Whereas this may be desirable in certain applications it is usually not desirable. In order to prevent such an electrical contact between a heat producing component and the heat sink to which it is thermally connected, an electrical insulator is preferably arranged between the component and the heat sink.

According to their designation, the heat sinks have a plate-like shape which means that they generally have the shape of a plate, i. e. they are generally flat with a thickness that is much smaller than their length and width. The terms length and width imply that they preferably have a generally rectangular shape but they may also have a different shape such as circular, oval or any other suitable shape.

At least one of the heat sinks but preferably both of them include a sheet of material with a high thermal conductivity. Since metals have a high thermal conductivity they are preferably used for this purpose. Metals such as silver, copper or gold would be very well suited but due to the costs and the wide availability aluminium sheets are preferably used. It is however to note that these materials may be used either pure or as a commercially available alloy.

In addition to the components already mentioned the power circuit usually includes further components. For example many power circuits deliver a DC voltage at their output wherefore they include a capacitive component at their output across which the DC voltage is provided. The power circuit therefore preferably includes a capacitor that is mounted on a PCB of the power supply. Since such a capacitor usually has a high capacity an electrolytic capacitor is advantageously used for this purpose.

Although electrolytic capacitors have a high capacity in relation to their size, such a capacitor is usually one of the largest components of such a power circuit. And since they are usually mounted on a PCB such that they extend orthogonally from the surface of the PCB the size of the capacitor is one of the main factors that influences the distance between the heat sinks of a power module and/or the distance between two adjacent power modules.

As mentioned above, the heat sinks of a power module are arranged at a specific distance. This distance is - among other factors - influenced by the number and thickness of the PCBs of a power module and those components of the power circuit that are mounted on these PCBs. Then the heat sinks can just be attached to the components that are to be thermally connected to the heat sinks. In order to enhance the structural stability of a power module and therewith also the whole power supply, at least one spacer is preferably arranged between and affixed to the heat sinks to keep them at the required distance. In case of rectangular heat sinks, such a spacer is preferably provided in each corner region of the heat sinks. Advantageously, insulating spacers are used to avoid electrical connections between them and not to reduce the insulation between them.

Since all power modules together form the power supply, the power supply is a modular power supply. To perform as a single power supply, the individual power modules usually have to be interconnected in one or another way. For example the input power signal has to be fed to the power circuit of each module, the output power signal has to be supplied to the external circuit and possibly some control and/or sensor signals have to be supplied to or by the module.

Such an interconnection of the power modules may for example be realised by connecting one or more external devices to a specified input/output power module and then connecting this input/output power module to another module and so on. In a similar way, the input/output power module could also be connected to any other power module. The connections can for example be realised by single lines, by corresponding buses or any other suitable means.
In a preferred embodiment, the power supply however includes an additional connector device which in turn is connected to every single power module of the power supply. These connections include the electrical connections but may also include mechanical connections. In this way all power modules can be made generally or actually identical which results in a simple and cheap power supply and also in decreased manufacturing and logistic costs.
The additional connector device is preferably implemented as a PCB, designated in the following as jointer PCB. The jointer PCB is electrically connected to at least one PCB of each power module and includes a connector for connecting the power supply to one or more external circuits that provide and/or receive the respective signals.
The jointer PCB is preferably arranged orthogonal to the first PCB of each power module and the interconnection to the PCBs of the power modules is preferably implemented by corresponding connectors such as for example plugs or the like. It is also possible that the jointer PCB has some openings in which the power module PCBs or a part of them can be inserted. By inserting the PCBs into these openings not only a mechanical connection is established but also the electrical connection may be established.
The solution of the invention regarding the electrically operated device is specified by the features of claim 13. According to the invention, such an electrically operated device includes a power supply as described above. The power supply receives the electrical power from a power source which is either internal or external of the electrical device. Such an internal power source may for example be a battery or the like and an external power source may be a power supply network to which the device is connected.

The solution of the invention regarding the method for providing such a power supply is specified by the features of claim 14. Such a method includes the steps of providing at least one power module by providing a first plate-like heat sink, a second plate-like heat sink, a first PCB and a power circuit, arranging the plate-like heat sinks in parallel at a distance and arranging the first PCB between the plate-like heat sinks.
According to the invention, the method further includes the steps of providing the power circuit with a planar transformer by providing a magnetic core and providing traces on the first PCB for forming windings of the planar transformer.
Other advantageous embodiments and combinations of features come out from the detailed description below and the totality of the claims.

### Brief description of the drawings

The drawings used to explain the embodiments show:
- Fig. 1: a schematic illustration of a first example of a power module for a power supply not part of the invention;
- Fig. 2: a schematic illustration of a second example of a power module for a power supply not part of the invention;
- Fig. 3: a schematic illustration of a third example of a power module for a power supply according to the invention;
- Fig. 4: a schematic illustration of a power supply according to the invention in a front view and
- Fig. 5: the power supply shown in fig. 4 in a side view.

In the figures, the same components are given the same reference symbols.

### Preferred embodiments

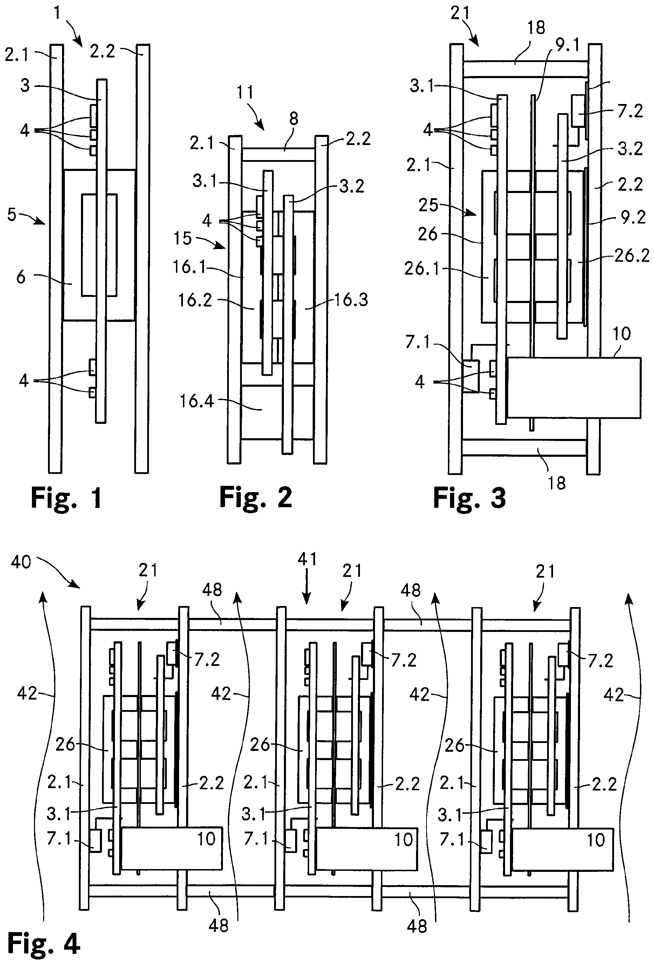

Fig. 1 shows a front view of a first example of a power module 1 for a power supply. Power modules according to Fig.1 are not part of the invention, but are useful for understanding it. The power module 1 includes two parallel aluminium sheets 2.1, 2.2 as the heat sinks. The front view of fig. 1 just shows the cross section of these aluminium sheets 2.1, 2.2. Between the aluminium sheets 2.1, 2.2 a PCB 3 is arranged in parallel to the heat sinks. On the PCB 3 a number of circuit components 4 are mounted. The power module 1 further includes a planar transformer 5 with a magnetic core 6 which has the shape of an O. The magnetic core 6 is for example composed of two U-shaped core parts as known in the art. The PCB 3 includes two holes (not shown) such that the legs of the magnetic core 6 can be fed through the holes to assemble the magnetic core 6. The windings of the planar transformer 5 are realised by traces (not shown) provided on a layer of the PCB 3. This layer may for example be a layer on a surface of the PCB 3 such as for example the surface where the components 4 are mounted.

The PCB 3 may either be a single-layer PCB having just one layer for providing traces or it may a multi-layer PCB having more than one layer for providing PCBs. These layers may either be on one or both surfaces of the PCB and/or the PCB may include one or more inner layers that carry windings for the transformer.

The heat sinks are arranged such that the aluminium sheet 2.1 is in thermal contact with the magnetic core 6 on one side of the core and that the aluminium sheet 2.2 is in thermal contact with the magnetic core 6 an opposed side of the core. The aluminium sheets 2.1, 2.2 are for example glued, bonded or otherwise sticked to the magnetic core thereby ensuring a good heat transfer from the core to the aluminium sheets 2.1, 2.2 for example by using a glue with a high heat conductivity. The aluminium sheets 2.1, 2.2 may also be clamped together thereby also clamping the core between them.

Fig. 2 shows a second example of a power module 11 for a power supply. Power modules according to Fig. 2 are not part of the invention, but are useful for understanding it. Again a front view of the power module 11 is shown. The power module 11 includes two parallel aluminium sheets 2.1, 2.2 as the heat sinks and two PCBs 3.1, 3.2 are arranged between the aluminium sheets 2.1, 2.2 and in parallel to them. A spacer 8 is provided at the top (according to the depiction in fig. 2) of the power module 11 to keep the aluminium sheets 2.1, 2.2 a defined distance to each other.

The power module 11 further includes a planar transformer 15 with a magnetic core 16.1 which has the shape of an eight. The magnetic core 16.1 is for example composed of two E-shaped core parts 16.2, 16.3 that are put together with facing legs. On the PCB 3.1 a number of circuit components 4 are mounted. The PCB 3.1 includes three holes (not shown) for the three legs of the magnetic core 16.1. The primary windings of the planar transformer 15 are realised by traces (not shown) on the PCB 3.1 and the secondary windings of the planar transformer 15 are realised by traces (not shown) on the PCB 3.2. As already mentioned in connection with fig. 1, both PCBs 3.1, 3.2 may be either single- or multi-layer PCBs and the traces may be provided on one or more of such layers.

The power module 11 includes a second magnetic core 16.4 that is either a part of the planar transformer 15 or part of another inductive element (not shown) such as another transformer or an inductor.

Both magnetic cores 16.1, 16.4 are thermally connected to both aluminium sheets 2.1, 2.2. The thermal connection between the heat sinks and the cores also stabilizes the power module 11 mechanically and - together with the spacer 8 - keeps the heat sinks at the desired distance.

Fig. 3 depicts a third example of a power module 21 for a power supply according to the invention. The power module 21 also includes two aluminium sheets 2.1, 2.2 as heat sinks. The power module 21 has a generally rectangular shape that is mainly defined by the two rectangular aluminium sheets 2.1, 2.2.

The power module 21 includes two PCBs 3.1, 3.2 and a planar transformer 25 with an 8-shaped magnetic core 26 that consists of two E-shaped core parts 26.1, 26.2. Accordingly, both PCBs 3.1, 3.2 have three holes for the three legs of the magnetic core 26 and bear the windings for the planar transformer 25 in the form of traces that are passed around the holes. In the example shown, the core part 26.2 is assigned to the primary side of the planar transformer 25 wherefore the PCB 3.2 bears the primary windings and the core part 26.1 is assigned to the secondary side of the planar transformer 25 wherefore the PCB 3.1 bears the secondary windings. Accordingly, the aluminium sheet 2.2 is assigned to the primary of the planar transformer 25 and the aluminium sheet 2.1 is assigned to its secondary.

An insulator 9.1 is arranged between the core parts 26.1, 26.2 to isolate the primary from the secondary of the planar transformer 25. The length and width of the insulator 9.1 is larger than length and width of the magnetic core 26 such that it protrudes the magnetic core 26 on each side. Accordingly, the insulator 9.1 increases the safety isolation between the primary and the secondary of the planar transformer 25. The insulator 9.1 is implemented as a FR4 PCB having a thickness of 0.5 mm and also includes traces that form windings of the planar transformer 25.

Whereas the core part 26.2 is in thermal contact with the aluminium sheet 2.2, the core part is not in thermal contact with the aluminium sheet 2.1. The thermal contact between the core part 26.2 and the aluminium sheet 2.2 is realised by an insulator 9.2 arranged between them.

In this case, a plurality of spacers 18 is provided, particularly one in each corner region of the power module 21 to keep the aluminium sheets 2.1, 2.2 at the desired distance to each other. Furthermore, the spacers 18 are made of an isolating material in order not to weaken the isolation between the primary and the secondary.

The power circuit of the power module 21 includes a number of components 4 mounted on the secondary PCB 3.1 on the surface facing the primary heat sink, the aluminium sheet 2.1. In this example the power circuit further includes a heat producing semiconductor 7.1 in the secondary that is also mounted on the secondary PCB 3.1. And the power circuit includes another heat producing semiconductor 7.2 in the primary that is accordingly mounted on the primary PCB 3.2. The semiconductor 7.1 is a transistor and the semiconductor 7.2 is a diode. Both semiconductors 7.1, 7.2 are mounted on the respective PCB 3.1, 3.2 such that the best possible heat transfer to the respective heat sink is achieved. In the example shown both semiconductors 7.1, 7.2 have pins that are inserted in corresponding holes in the PCBs 3.1, 3.2 and that are bended such that the body of the semiconductors lies parallel to the heat sink and in thermal contact to it. The semiconductor 7.1 is in direct contact with the aluminium sheet 2.1 but an insulator 9.3 is provided between the semiconductor 7.2 and the aluminium sheet 2.2. It is clear that the power circuit may include several transistors and/or diodes mounted on the PCBs 3.1, 3.2 in the same way.

At its output, i. e. in its secondary, the power circuit includes an electrolytic capacitor 10 which is mounted on the PCB 3.1. The width of the power module 21 is defined by the distance between the two heat sinks. It is generally desirable to make this distance as small as possible to reduce the space requirements of the module and therewith of the power supply. Accordingly, the width directly depends on the width of the magnetic core 26, the exact position of the PCBs 3.1, 3.2 in relation to the magnetic core and the size of the electrical and/or mechanical components mounted on the PCBs 3.1, 3.2. Since the electrolytic capacitor 10 is a very large component, it is not considered in this example for determining the width of the power module 21.

The PCBs 3.1, 3.2 are arranged around the core legs such that they have the maximum possible distance to each other. This results in a large space between the PCBs 3.1, 3.2 which reduces the losses caused by air gap fringing.

In a particular example the power module 21 is provided with an AC input voltage of about 400 V and delivers an output power of about 300 W at a DC output voltage of about 24 V. The aluminium sheets 2.1, 2.2 have a thickness of 2 mm, a width of 8 cm and a length of 12 cm which results in a cooling area of 96 cm² per aluminium sheet 2.1, 2.2. The resulting width of the power module (including the aluminium sheet 2.1, 2.2) is about 27 mm. The length of the spacers 18 is chosen accordingly. The overall width of a power module 21, i. e. including the electrolytic capacitor 10 of course depends on the height of the electrolytic capacitor 10 and is in the range of about 35 to 45 mm.

In operation, the power module is cooled by convection, i.e. by an air flow that mainly flows along the outer sides of both aluminium sheets 2.1, 2.2. However, a small part of the air flow also flows through the power module 21, i.e. between the aluminium sheets 2.1, 2.2.

The power circuit for example includes a PFC (power factor correction) circuit and a power output stage in a single power module 21.

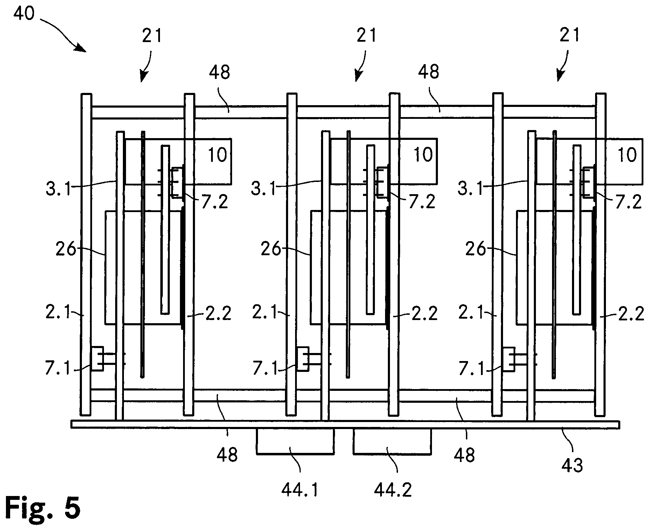

Fig. 4 shows a power supply 40 according to the invention in a front view and fig. 5 shows the power supply 40 in a side view, i. e. in a direction according to the arrow 41. The power supply 40 includes three power modules 21 as shown in fig. 3. For reasons of clarity, only some reference numerals of the parts and elements of the power modules 21 are shown in fig. 4 and 5."

The three power modules 21 of the power supply 40 are provided in parallel and connected together by further spacers 48 arranged in line with the spacers 18 of the power modules 21. In the example shown the spacers 48 are the same as the spacers 18 such that the two adjacent aluminium sheets of two neighbouring power modules have the same distance as the two aluminium sheets of a single module 21. The spacers 48 can however also have a different length such that the distance between two neighbouring modules is larger or smaller.

On the outside of each power module 21, i. e. between two neighbouring power modules and on the outer sides of the power supply 40, the convection air flow is schematically shown by arrows 42. The much smaller air flow through the power modules 21 is not designated.

An additional PCB 43 which previously is designated as a jointer PCB is arranged at the front of the power supply 40. This PCB 43 is however not shown in fig. 4 because the power modules would not be visible anymore.

The PCB 43 includes an input connector 44.1 and an output connector 44.2 for connecting the power supply 40 to a power source and to a load device that consumes electrical energy. The connectors 44.1, 44.2 are shown to be laterally displaced but they may also be arranged vertically one upon the other, for example in the region of the upper and lower edge of the PCB 43.

The PCB 3.1 of each power module 21 is mechanically as well as electrically connected to the PCB 43 such as to receive the electrical power from the source and to deliver the electrical power to the load or loads. The input and output connectors 44.1, 44.2 may also provide pins to connect for example control signals provided externally (for example by an superior control) for controlling the power modules and/or signals provided by the power modules 21 such as for example sensor signals.

In summary, it is to be noted that the invention enables to integrate a large heat sink area using PCBs and aluminium sheets within a power module and where the heat produced by certain components such as diodes, transistors and magnetic cores mounted on the PCBs are arranged such that they are in direct contact with a heat sink or that they are cooled by the PCB.

The invention therefore enables an enhanced heat flow from these components to the heat sinks and further to the air flowing along the heat sinks thereby allowing for a simple construction, low costs and an improved performance regarding cooling as well as electrical efficiency.

## Claims

1. Power supply (40) including at least one power module (21), where each power module (21) includes a first plate-like heat sink (2.1), a second plate-like heat sink (2.2), a first PCB (3.1) and a power circuit, where the plate-like heat sinks (2.1, 2.2) are arranged in parallel at a distance and the first PCB (3.1) is arranged between the plate-like heat sinks (2.1, 2.2)and the power circuit includes a planar transformer (25) with windings and a magnetic core (26) wherein the windings are formed by traces on the first PCB (3.1) and wherein the magnetic core (26) is thermally connected to at least one of the plate-like heat sinks (2.1, 2.2) and wherein the magnetic core (26) includes two core parts (26.1, 26.2), **characterised in that** an electrical insulator (9.1) is arranged between the two core parts (26.1, 26.2) and the insulator (9.1) defines a gap between the magnetic core parts (26.1, 26.2).

2. Power supply according to claim 1, wherein said first PCB (3.1) is a multilayer PCB where said traces are provided on different layers of said PCB (3.1).

3. Power supply according to any of claims 1 to 2, wherein said insulator (9.1) is formed by a PCB that preferably includes traces forming windings of the planar transformer (25).

4. Power supply according to any of claims 1 to 3, wherein one of the core parts (26.2) is thermally connected to one of the plate-like heat sinks (2.2), and where the other magnetic core part is thermally connected to another one of the plate-like heat sinks.

5. Power supply according to any of claims 1 to 4, wherein the first PCB (3.1) is arranged in parallel to the plate-like heat sinks (2.1, 2.2).

6. Power supply according to any of claims 1 to 5, including at least one second PCB (3.2) arranged in parallel to the first PCB (3.1).

7. Power supply according to any of claims 1 to 6, wherein a first heat producing component (7.1) of the power circuit is thermally connected to one of the plate-like heat sinks (2.1, 2.2).

8. Power supply according to claim 7, wherein a second heat producing component (7.2) of the power circuit is thermally connected to another one of the plate-like heat sinks (2.2).

9. Power supply according to any of claims 7 to 8, wherein an electrical insulator (9.3) is arranged between a heat producing component (7.2) and the plate-like heat sink (2.2) to which it is thermally connected.

10. Power supply according to any of claims 1 to 9, wherein at least one of the plate-like heat sinks, preferably both plate-like heat sinks, includes a sheet of material (2.1, 2.2) with a high thermal conductivity, particularly a sheet of a metal such as aluminium.

11. Power supply according to any of claims 1 to 10, wherein the power circuit includes an electrolytic capacitor (10) mounted on a PCB (3.1).

12. Power supply according to any of claims 1 to 11, including a jointer PCB (43) electrically connected to at least one PCB (3.1) of each power module (21), wherein the jointer PCB (43) includes a connector (44.1, 44.2) for connecting the power supply (40) to an external circuit and wherein the jointer PCB (43) is preferably arranged orthogonal to the first PCB (3.1) of each power module (21).

13. Electrically operated device, including a power supply according to any of the previous claims.

14. Method for providing a power supply (40) including the steps of providing at least one power module (21) by providing a first plate-like heat sink (2.1), a second plate-like heat sink (2.2), a first PCB (3.1) and a power circuit, arranging the plate-like heat sinks (2.1, 2.2) in parallel at a distance and arranging the first PCB (3.1) between the plate-like heat sinks (2.1, 2.2), providing the power circuit with a planar transformer (25) by providing a magnetic core (26) and providing traces on the first PCB (3.1) for forming windings of the planar transformer (25), **characterised by** the steps of arranging an electrical insulator (9.1) between two core parts (26.1,26.2) which are part of the magnetic core (26), and defining a gap between the magnetic core parts (29.1, 26.2) with the insulator (9.1).

## Patentansprüche

1. Stromversorgung (40) aufweisend mindestens ein Leistungsmodul (21), wobei jedes Leistungsmodul (21) einen ersten plattenförmigen Kühlkörper (2.1), einen zweiten plattenförmigen Kühlkörper (2.2), eine erste Leiterplatte (3.1) und einen Stromkreis umfasst, wobei die plattenförmigen Kühlkörper (2.1, 2.2) parallel in einem Abstand voneinander angeordnet sind und die erste Leiterplatte (3.1) zwischen den plattenförmigen Kühlkörpern (2.1, 2.2) angeordnet ist und der Stromkreis einen Planartransformator (25) mit Wicklungen und einem Magnetkern (26) aufweist, wobei die Wicklungen durch Leiterbahnen auf der ersten Leiterplatte (3.1) gebildet sind und wobei der Magnetkern (26) thermisch mit mindestens einem der plattenförmigen Kühlkörper (2.1, 2.2) verbunden ist und wobei der Magnetkern (26) zwei Kernteile (26.1, 26.2) aufweist, **dadurch gekennzeichnet, dass** zwischen den zwei Kernteilen (26.1, 26.2) ein elektrischer Isolator (9.1) angeordnet ist und der Isolator (9.1) einen Spalt zwischen den Magnetkernteilen (26.1, 26.2) definiert.

2. Stromversorgung nach Anspruch 1, wobei die erste Leiterplatte (3.1) eine mehrlagige Leiterplatte ist, in der besagte Leiterbahnen auf verschiedenen Lagen der besagten Leiterplatte (3.1) bereitgestellt sind.

3. Stromversorgung nach einem der Ansprüche 1 bis 2, wobei der Isolator (9.1) durch eine Leiterplatte gebildet ist, die vorzugsweise Leiterbahnen, welche Wicklungen des Planartransformators (25) bilden, aufweist.

4. Stromversorgung nach einem der Ansprüche 1 bis 3, wobei einer der Kernteile (26.2) thermisch mit einem der plattenförmigen Kühlkörper (2.2) verbunden ist, und wobei der andere Magnetkernteil thermisch mit einem anderen der plattenförmigen Kühlkörper verbunden ist.

5. Stromversorgung nach einem der Ansprüche 1 bis 4, wobei die erste Leiterplatte (3.1) parallel zu den plattenförmigen Kühlkörpern (2.1, 2.2) angeordnet ist.

6. Stromversorgung nach einem der Ansprüche 1 bis 5, aufweisend mindestens eine zweite Leiterplatte (3.2), die parallel zur ersten Leiterplatte (3.1) angeordnet ist.

7. Stromversorgung nach einem der Ansprüche 1 bis 6, wobei eine erste Wärme erzeugende Komponente (7.1) des Stromkreises thermisch mit einem der plattenförmigen Kühlkörper (2.1, 2.2) verbunden ist.

8. Stromversorgung nach Anspruch 7, wobei eine zweite Wärme erzeugende Komponente (7.2) des Stromkreises thermisch mit einem anderen der plattenförmigen Kühlkörper (2.2) verbunden ist.

9. Stromversorgung nach einem der Ansprüche 7 bis 8, wobei ein elektrischer Isolator (9.3) zwischen einer Wärme erzeugenden Komponente (7.2) und dem plattenförmigen Kühlkörper (2.2), mit dem sie thermisch verbunden ist, angeordnet ist.

10. Stromversorgung nach einem der Ansprüche 1 bis 9, wobei mindestens einer der plattenförmigen Kühlkörper, vorzugsweise beide plattenförmigen Kühlkörper, eine Platte aus einem Material (2.1, 2.2) mit einer hohen Wärmeleitfähigkeit, insbesondere eine Platte aus einem Metall wie zum Beispiel Aluminium, aufweist.

11. Stromversorgung nach einem der Ansprüche 1 bis 10, wobei der Stromkreis einen Elektrolytkondensator (10) aufweist, der auf einer Leiterplatte (3.1) angebracht ist.

12. Stromversorgung nach einem der Ansprüche 1 bis 11, aufweisend eine Verbinder-Leiterplatte (43), die elektrisch mit mindestens einer Leiterplatte (3.1) jedes Leistungsmoduls (21) verbunden ist, wobei die Verbinder-Leiterplatte (43) einen Stecker (44.1, 44.2) zum Anschließen der Stromversorgung (40) an einen externen Schaltkreis aufweist, und wobei die Verbinder-Leiterplatte (43) vorzugsweise im rechten Winkel zur ersten Leiterplatte (3.1) jedes Leistungsmoduls (21) angeordnet ist.

13. Elektrisch betriebene Vorrichtung, aufweisend eine Stromversorgung nach einem der vorstehenden Ansprüche.

14. Verfahren zur Bereitstellung einer Stromversorgung (40) umfassend die Schritte des Bereitstellens mindestens eines Leistungsmoduls (21) durch Bereitstellen eines ersten plattenförmigen Kühlkörpers (2.1), eines zweiten plattenförmigen Kühlkörpers (2.2), einer ersten Leiterplatte (3.1) und eines Stromkreises, des Anordnens der plattenförmigen Kühlkörper (2.1, 2.2) parallel in einem Abstand voneinander und des Anordnens der ersten Leiterplatte (3.1) zwischen den plattenförmigen Kühlkörpern (2.1, 2.2), des Bereitstellens des Stromkreises mit einem Planartransformator (25) durch Bereitstellen eines Magnetkerns (26) und Bereitstellen von Leiterbahnen auf der ersten Leiterplatte (3.1) zur Bildung von Wicklungen des Planartransformators (25), **gekennzeichnet durch** die Schritte des Anordnens eines elektrischen Isolators (9.1) zwischen zwei Kernteilen (26.1, 26.2), welche Teil des Magnetkerns (26) sind, und des Definierens eines Spalts zwischen den Magnetkernteilen (29.1, 26.2) mit dem Isolator (9.1).

## Revendications

1. Alimentation électrique (40) comprenant au moins un module d'alimentation (21), chaque module d'alimentation (21) comprenant un premier dissipateur thermique en forme de plaque (2.1), un second dissipateur thermique en forme de plaque (2.2), une première carte de circuit imprimé (3.1) et un circuit d'alimentation, dans laquelle les dissipateurs thermiques en forme de plaque (2.1, 2.2) sont agencés parallèlement à une distance et la première carte de circuit imprimé (3.1) est agencée entre les dissipateurs thermiques en forme de plaque (2.1, 2.2), et le circuit d'alimentation comprend un transformateur planaire (25) avec des enroulements et un noyau magnétique (26), dans laquelle les enroulements sont formés par des traces sur la première carte de circuit imprimé (3.1), et dans laquelle le noyau magnétique (26) est connecté thermiquement à au moins l'un des dissipateurs thermiques en forme de plaque (2.1, 2.2), et dans laquelle le noyau magnétique (26) comprend deux parties de noyau (26.1, 26.2), **caractérisée en ce qu'**un isolant électrique (9.1) est agencé entre les deux parties de noyau (26.1, 26.2), et l'isolant (9.1) définit un espace entre les parties de noyau magnétique (26.1, 26.2).

2. Alimentation électrique selon la revendication 1, dans laquelle ladite première carte de circuit imprimé (3.1) est une carte de circuit imprimé multicouche où lesdites traces sont fournies sur différentes couches de ladite carte de circuit imprimé (3.1).

3. Alimentation électrique selon l'une quelconque des revendications 1 à 2, dans laquelle ledit isolant (9.1) est formé par une carte de circuit imprimé qui comprend, de préférence, des traces formant des enroulements du transformateur planaire (25).

4. Alimentation électrique selon l'une quelconque des revendications 1 à 3, dans laquelle l'une des parties de noyau (26.2) est connectée thermiquement à l'un des dissipateurs thermiques en forme de plaque (2.2) et l'autre partie de noyau magnétique est connectée thermiquement à un autre des dissipateurs thermiques en forme de plaque.

5. Alimentation électrique selon l'une quelconque des revendications 1 à 4, dans laquelle la première carte de circuit imprimé (3.1) est agencée parallèlement aux dissipateurs thermiques en forme de plaque (2.1, 2.2).

6. Alimentation électrique selon l'une quelconque des revendications 1 à 5, comprenant au moins une seconde carte de circuit imprimé (3.2) agencée parallèlement à la première carte de circuit imprimé (3.1).

7. Alimentation électrique selon l'une quelconque des revendications 1 à 6, dans laquelle un premier composant de production de chaleur (7.1) du circuit d'alimentation est connecté thermiquement à l'un des dissipateurs thermiques en forme de plaque (2.1, 2.2).

8. Alimentation électrique selon la revendication 7, dans laquelle un second composant de production de chaleur (7.2) du circuit d'alimentation est connecté thermiquement à un autre des dissipateurs thermiques en forme de plaque (2.2).

9. Alimentation électrique selon l'une quelconque des revendications 7 à 8, dans laquelle un isolant électrique (9.3) est agencé entre un composant de production de chaleur (7.2) et le dissipateur thermique en forme de plaque (2.2) auquel il est thermiquement connecté.

10. Alimentation électrique selon l'une quelconque des revendications 1 à 9, dans laquelle au moins l'un des dissipateurs thermiques en forme de plaque, de préférence les deux dissipateurs thermiques en forme de plaque, comprend une feuille de matériau (2.1, 2.2) à haute conductivité thermique, en particulier une feuille d'un métal tel que l'aluminium.

11. Alimentation électrique selon l'une quelconque des revendications 1 à 10, dans laquelle le circuit d'alimentation comprend un condensateur électrolytique (10) monté sur une carte de circuit imprimé (3.1).

12. Alimentation électrique selon l'une quelconque des revendications 1 à 11, comprenant une carte de circuit imprimé de liaison (43) connectée électriquement à au moins une carte de circuit imprimé (3.1) de chaque module d'alimentation (21), dans laquelle la carte de circuit imprimé de liaison (43) comprend un connecteur (44.1, 44.2) pour connecter l'alimentation électrique (40) à un circuit externe, et dans laquelle la carte de circuit imprimé de liaison (43) est de préférence agencée orthogonalement à la première carte de circuit imprimé (3.1) de chaque module d'alimentation (21).

13. Dispositif à commande électrique, comprenant une alimentation électrique selon l'une quelconque des revendications précédentes.

14. Procédé de fourniture d'une alimentation électrique (40) comprenant les étapes consistant à fournir au moins un module d'alimentation (21) en fournissant un premier dissipateur thermique en forme de plaque (2.1), un second dissipateur thermique en forme de plaque (2.2), une première carte de circuit imprimé (3.1) et un circuit d'alimentation, agencer les dissipateurs thermiques en forme de plaque (2.1, 2.2) parallèlement à une distance et agencer la première carte de circuit imprimé (3.1) entre les dissipateurs thermiques en forme de plaque (2.1, 2.2), munir le circuit d'alimentation d'un transformateur planaire (25) en fournissant un noyau magnétique (26) et en fournissant des traces sur la première carte de circuit imprimé (3.1) pour former des enroulements du transformateur planaire (25), **caractérisé par** les étapes d'agencement d'un isolant électrique (9.1) entre deux parties de noyau (26.1, 26.2) qui font partie du noyau magnétique (26), et définir un espace entre les parties de noyau magnétique (29.1, 26.2) avec l'isolant (9.1).
